Europäisches Patentamt

European Patent Office

Office européen des brevets

(11) Publication number: **0 361 656**
**A1**

## EUROPEAN PATENT APPLICATION

(21) Application number: 89307637.2

(22) Date of filing: 27.07.89

(51) Int. Cl.5 **G01R 29/22 , G01R 35/00**

(30) Priority: 07.09.88 GB 8820940

(43) Date of publication of application:
04.04.90 Bulletin 90/14

(84) Designated Contracting States:
DE FR IT SE

(71) Applicant: MARCONI INSTRUMENTS LIMITED
The Grove Warren Lane
Stanmore Middlesex HA7 4LY(GB)

(72) Inventor: Bradley, Liam Patrick
6, Pine Grove
Dunfermline Fife KY11 5BD Scotland(GB)

(74) Representative: MacKenzie, Ian Alastair
Robert
The General Electric Company, p.l.c. Central
Patent Department Wembley Office Hirst
Research Center East Lane
Wembley Middlesex HA9 7PP(GB)

(54) Method and apparatus for testing transducers.

(57) The invention concerns apparatus for testing a transducer of the kind which normally operates in a liquid medium such as water. The apparatus comprises a loading rod (14) havng an elongated solid body so dimensioned as to simulate the normal operating acoustic impedance presented to the transducer to be tested by its normal operating medium, means (20, 10, 11) for locating the loading rod over the active head of the transducer, and spring means (16) for biasing the rod into contact with the transducer. The means for locating said rod preferably comprise a housing (11) having a reaction plate (10) carrying a compression spring (16) for biasing the loading rod (14) towards the transducer to be tested.

Fig.1.

## METHOD AND APPARATUS FOR TESTING TRANSDUCERS

The present invention concerns apparatus for testing one or an array of more than one piezo-electric or equivalent type transducers.

One application involving the use of piezo-electric transducers is in the underwater generation or detection of acoustic signals. In such an application the plurality of transducers may be used in an assembly such as a Phased Array.

In order to test such transducers it is either necessary to surround the transducers in the medium in which they are intended to operate or simulate the normal acoustic impedance presented to them by the medium. The first of these procedures presents problems when the operating medium is a fluid such as water. It is quite possible that testing transducers intended to operate in a medium such as water in a medium, i.e. air, which does not give the same loading can actually cause damage to the transducer under test.

The present invention has for an object to provide apparatus for testing piezo-electric transducers intended for operation in a liquid medium which would normally be water, without the need for immersing the transducers in the liquid medium.

Accordingly the present invention consists in apparatus for testing a transducer comprising a loading rod having an elongated solid body so dimensioned as to simulate the normal operating acoustic impedance presented to the transducer to be tested by its normal operating medium, means for locating the loading rod over the active head of a transducer and spring means for biasing the rod into contact with the transducer.

Preferably the biasing provided by the spring means is variable.

The apparatus may be capable of mounting a plurality of rods over an array of transducers.

In order that the present invention may be more readily understood, an embodiment thereof will now be described by way of example and with reference to the accompanying drawings, in which:

Figure 1 is a section through apparatus according to the present invention, and

Figure 2 is a section through a transducer rod for use in apparatus according to the present invention.

Normally there will be more than two rods 14 so that an array of transducers can be tested simultaneously. In operation the rods 14 are located above the transducer array, which is not shown.

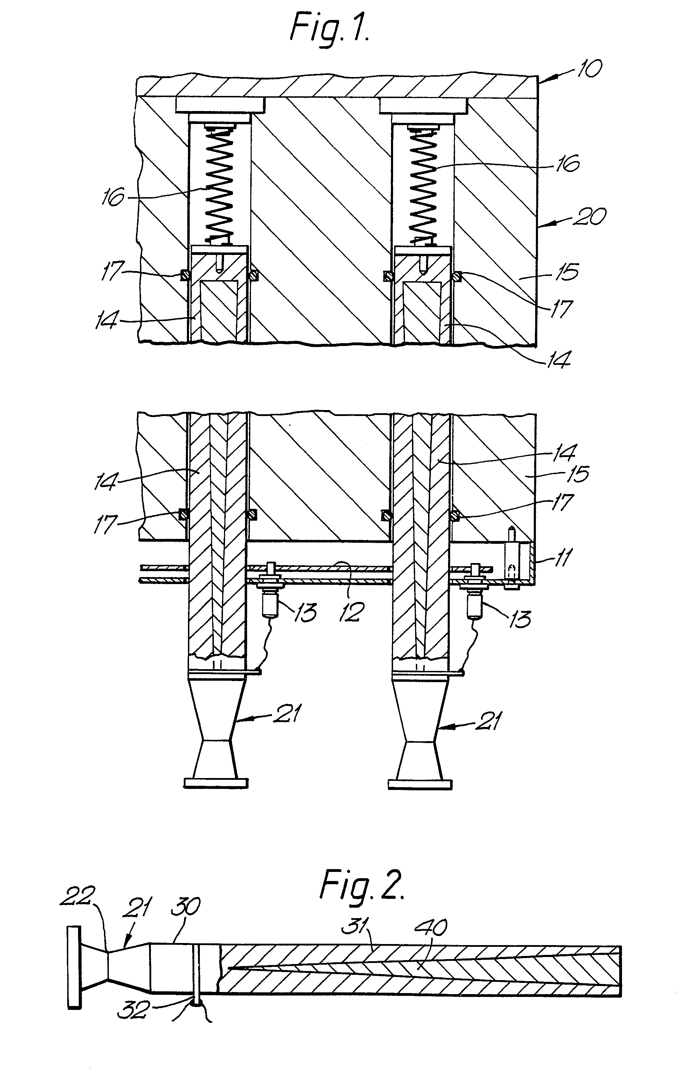

Referring now to Figure 2 of the drawings, this shows a rod 14 in greater detail.

Referring now to Figure 1 of the drawings this shows transducer testing apparatus comprising a frame generally indicated at 20 and comprising a top, or reaction, plate 10 and a housing 11. The housing 11 mounts a PCB 12 and a pair of 2 pin push fit connectors 13. Each of the connectors 13 is associated with a transducer to be tested and a rod 14 which simulates the acoustic impedance presented to the transducers by their normal operating environment. This environment is usually water. Located between the plate 10 and housing 11 is a main housing 15 which is solid apart from bores in which the rods 14 are mounted. This housing 15 provides both a solid support for the rods 14 and a heat sink. As can be seen from the drawing each rod 14 is biased towards the transducer to be tested by a helical spring 16. Accurate alignment of the rods 14 is provided by O - rings 17.

Essentially each rod 14 is an acoustic waveguide made from a rigid, low-loss material such as an acrylic polymer. One suitable material is Perspex (RTM). The purpose of the rod 14 is to present a mechanical impedance to a piezo-electric transducer which corresponds to the complex load, normally referred to as $Z_l$, which the transducer sees when immersed in water. The load represented by the rod is equivalent to a mass in series with radiation resistance both of which vary with frequency.

As can be seen from Figure 2, the transducer end 21 of the waveguide rod 14 has a waisted portion indicated at 22. This waisted portion is made of a pair of opposed frusto-conical sections.

It can also be seen that the main body of the rod 14 has been separated into two portions 30, 31 and a transducer 32 placed between the two portions. In its operational state the two portions of the rod would be bonded to either side of transducer 32. The transducer 32 is capable of monitoring the amplitude and phase of the signals output by a transducer under test which, as stated, is located beneath the active end of rod 14. The transducer 32 can also be used bi-directionally to inject a signal into the rod to simulate an external source and thus test the receiving abilities of any transducer under test.

The transducer 32 is made from a piezo-electric polymer. Materials such as Copolymer PVDF or PVF2 are equally suitable. Also as can be seen from figure 2 the main body of the rod-like acoustic waveguide 14 is provided with an internal tapered bore 40 with the taper extending towards the transducer end 21 of the rod. The bore 40 is filled with a core of material which has a close match of acoustic impedance to the material of rod 14 but has a very high acoustic loss factor. In the embodiment being described a suitable core material is a metal loaded epoxy partially polymerised. The degree of polymerisation selected to achieve the desired acoustic characteristics. Alternative materials may include soft plastics mixed with some high density loading material.

The body of the rod provides the main acoustic load and the provision of the tapered bore 40 and its core is intended to optimise the energy absorbing performance of the acoustic load. The exact nature of the taper in the bore is not critical but at some point within the rod the core material 41 must appear to occupy the cross-sectional area of the body.

## Claims

1. Apparatus for testing a transducer and characterised in that it comprises a loading rod (14) having an elongated solid body so dimensioned as to simulate the normal operating acoustic impedance presented to the transducer to be tested by its normal operating medium, means (20, 10,11) for locating the loading rod over the active head of the transducer, and spring means (16) for biasing the rod into contact with the transducer.

2. Apparatus as claimed in Claim 1, and further characterised in that the means for locating said rod comprise a housing (11) having a reaction plate (10) carrying a compression spring (16) for biasing the loading rod (14) towards the transducer to be tested.

3. Apparatus as claimed in Claim 2, and further characterised in that said housing (11) is solid apart from one or more bores, each bore being adapted to mount a loading road.

4. Apparatus as claimed in either of Claims 2 or 3, and characterised in that a PCB (12) is mounted on said housing (11) for the or each loading rod.

# Fig.1.

# Fig.2.

## DOCUMENTS CONSIDERED TO BE RELEVANT

EP 89307637.2

| Category | Citation of document with indication, where appropriate, of relevant passages | Relevant to claim | CLASSIFICATION OF THE APPLICATION (Int. Cl.4) |
|---|---|---|---|
| X | US - A - 4 238 725 (KARPLUS) * Abstract; fig. 1,2 * | 1 | G 01 R 29/22 G 01 R 35/00 |
| A | ---- | 2-4 | |
| | | | TECHNICAL FIELDS SEARCHED (Int. Cl.4) |
| | | | G 01 D 18/00 G 01 R 29/00 G 01 R 35/00 |

The present search report has been drawn up for all claims

| Place of search | Date of completion of the search | Examiner |
|---|---|---|
| VIENNA | 30-11-1989 | KUNZE |